# EUROPÄISCHE PATENTSCHRIFT

(11) **EP 0 924 316 B1**
(45) Veröffentlichungstag und Bekanntmachung des Hinweises auf die Patenterteilung: **15.11.2006**
(21) Anmeldenummer: 98123847.0
(22) Anmeldetag: 15.12.1998
(51) Int. Cl.: C23C 14/06, C23C 30/00

(54) **Verfahren zum Abscheiden von Schichtsystemen**
Method for depositing coating systems
Procédé de fabrication pour systèmes de couches

(30) Priorität: 18.12.1997 DE 19756588
(43) Veröffentlichungstag der Anmeldung: 23.06.1999
(73) Patentinhaber: hartec GmbH, 72510 Stetten a.k.M. (DE)
(72) Erfinder: dos Santos Pereira Ribeiro, Carlos Antonio, 72458 Albstadt Lautlingen (DE)
(74) Vertreter: Strych, Werner Maximilian Josef

(56) Entgegenhaltungen:
- EP-A- 0 448 720
- EP-A- 0 592 986
- KNOTEK O ET AL: "THE STRUCTURE AND COMPOSITION OF TI-ZR-N, TI-AI-ZR-N AND TI-AI-V-N COATINGS" MATERIALS SCIENCE AND ENGINEERING A: STRUCTURAL MATERIALS: PROPERTIES, MICROSTRUCTURE & PROCESSING, Bd. A105/106, 1. Januar 1988, Seiten 481-488, XP000108123
- PATENT ABSTRACTS OF JAPAN vol. 018, no. 042 (P-1680), 21. Januar 1994 & JP 05 266519 A (TOSHIBA CORP), 15. Oktober 1993

## Beschreibung

### I. Anwendungsgebiet

Die Erfindung betrifft ein Verfahren zur Abscheidung eines auf Aluminium, Zirkonium und Stickstoff basierenden Schichtsystems.

### II. Technischer Hintergrund

Es ist bekannt, auf Kunststoffspritzgußwerkzeuge zur Verringerung der Belagbildung, Verbesserung der Entformbarkeit und Verschleißverringerung Titannitrid-Beschichtungen einzusetzen. Diese Beschichtungen sind jedoch hinsichtlich ihrer Eigenschaften nicht zufriedenstellend.

Die gegenüber solchen Titannitrid-Beschichtungen hinsichtlich ihrer Oberflächeneigenschaften verbesserten Beschichtungen sind solche, die Chromnitrid als wesentlichen Bestandteil enthalten. Chromnitrid-Beschichtungen haben jedoch den Nachteil, daß die wichtigsten Eigenschaften während der Lebensdauer der Formwerkzeuge sich teilweise verändern, z. B. beim Zusammenfügen oder Vulkanisieren von Kautschukteilen, bei denen die Chromnitrid-Beschichtungen nach kurzer Einsatzdauer ihre adhäsionshemmende Wirkung verlieren.

Es ist ebenfalls bekannt, daß Zirkoniumnitrid-Beschichtungen in einigen Fällen und aufgrund ihrer Messingfarbe als dekorative Beschichtungen aufgebracht werden. Diese Beschichtungen bilden zwar an sich eine harte Oberfläche und sind gegen Laugen chemisch resistent, weisen aber vor allem metallische Bindungen auf.

In der EP-A-0 603 486 ist ein mehrstufiges Verfahren zur Beschichtung von Schneid- und Umformwerkzeugen mit ternären Hartstoffschichten wie Titanaluminiumnitrid, Zirkoniumaluminiumnitrid oder Chromaluminiumnitrid beschrieben. Die genannten Schichtmaterialien eignen sich zwar für Werkzeuge zur Metallbearbeitung, können jedoch nicht zur Verringerung der Kontaktadhäsion und Erhöhung der chemischen Beständigkeit von empfindlichen Oberflächen wie z. B. hochglanzpolierten Kunststoffextrusionswerkzeugen eingesetzt werden.

Bei diesen Werkstoffen weisen die festen Schichtkomponenten vorwiegend metallische Bindungen auf, wobei durch eingehende wissenschaftliche Versuche nachgewiesen wurde, daß alle Werkstoffe mit vorwiegend metallischer Bindung zu mehr oder minder starker Kontaktadhäsion neigen.

Aus der EP-A-0 592 986 ist eine ultradünne Verbundfolie aus einzelnen 0,2 bis 20 nm dicken Schichten zur Oberflächenbeschichtung von Werkzeugen bekannt. Die einzelnen Schichten bestehen dabei aus AIN oder ZrN und sind alternierend übereinander geschichtet, um ein Schichtsystem mit einer Gesamtdicke von etwa 0,5 bis 10 µm zu bilden.

Die EP-A-0 448 720 beschreibt ein Verfahren zur Beschichtung von WerkZeugen mit ZrAIN, wobei das atomare Verhältnis zwischen Al und Zr zwischen 0 und 1 liegt.

### III. Darstellung der Erfindung

### a) Technische Aufgabe

Aufgabe der Erfindung ist es daher, ein Verfahren zur Abscheidung eines Schichtsystems, das die Adhäsionsneigung und die Formbelagbildung deutlich verringert bzw. vollständig vermeidet, wobei eine gute Korrosionsbeständigkeit und eine höhere Verschleißfestigkeit gegen Abrasion erzielt werden kann, bereitzustellen.

### b) Lösung der Aufgabe

Erfindungsgemäß wird diese Aufgabe durch die Merkmale des Anspruchs 1 gelöst. Bevorzugte Ausführungsformen ergeben sich aus den Unteransprüchen.

Erfindungsgemäß weist zumindest eine Schicht kovalente Bindungen von Aluminiumnitrid und Zirkoniumnitrid auf. Durch die Zugabe von Zirkoniumnitrid tritt dabei erfindungsgemäß eine Stabilisierung der kovalenten Aluminiumnitrid-Bindung ein, wodurch eine hohe chemische Beständigkeit erzielt werden kann. Die Auswahl der chemischen Zusammensetzung und der weiteren Legierungselemente erfolgt dabei in Abhängigkeit der geforderten Eigenschaften, insbesondere bezüglich der Minimierung der adhäsiven Kräfte bei Kontakt mit zum Verkleben neigenden Werkstoffen, insbesondere Kunststoffe wie Duroplaste, Thermoplaste sowie Elastomere, Harze, Klebstoffe, Kautschuk, Gummi, Glas oder Aluminium.

Die verbesserten Eigenschaften der minimalen Adhäsionsneigung, der chemischen Beständigkeit gegen Laugen, des geringen Reibungskoeffizienten und des hohen Verschleißwiderstandes verleihen mit solchen Beschichtungen bzw. Schichtsystemen versehenen Formen und Bauteilen deutlich höhere Oberflächenqualität hinsichtlich Fertigungssicherung, Produktivität bzw. Anwendungsfreundlichkeit.

Erfindungsgemäß hat es sich als vorteilhaft erwiesen, das atomare Verhältnis zwischen Aluminium und Zirkonium bei 1 oder kleiner und > 0 einzustellen, da dadurch die adhäsiven Eigenschaften der erfindungsgemäß enthaltenen Beschichtung stark erhöht werden können. Bevorzugt liegt das Verhältnis zwischen Aluminium und Zirkonium bei 0,5 bis 0,7, wodurch die adhäsionshemmenden Eigenschaften der erfindungsgemäß enthaltenen Beschichtung stark erhöht werden.

Ein Vorteil der nach dem erfindungsgemäßen Verfahren enthaltenen Beschichtung ist dabei, daß diese optisch transparent oder mindestens teilweise lichtdurchläßig und/oder elektrisch nicht leitend ist oder zumindest einen hohen spezifischen elektrischen Widerstand aufweist.

Gemäß Anspruch 1 enthält die Schicht Bindungen der Typen Aluminiumnitrid und Zirkoniumnitrid, wobei das atomare Verhältnis zwischen Aluminium und Zirkonium 1 oder weniger beträgt. Vorzugsweise liegt das atomare Verhältnis zwischen Aluminium und Zirkonium bei 0,5 oder weniger, insbesondere bei 0,25 bis 0,45, wodurch die Verschleißfestigkeit wesentlich erhöht werden kann und insbesondere eine hohe chemische Beständigkeit der so aufgebrachten Beschichtung erzielt wird.

Es hat sich als vorteilhaft erwiesen, daß die durch das erfindungsgemäße Verfahren erthaltenen Beschichtungen eine Dicke von zumindest 50 nm aufweisen. Gemäß einer bevorzugten Ausführungsform ist die Beschichtung mindestens zwischen 200 nm und 2 µm dick für z.B. optische Anwendungen und zur Erfüllung der hohen Anforderungen an die Oberflächengüte oder zwischen 2 µm bis 6 µm für z.B. Anwendungen in der Kunststoffverarbeitung zur Vermeidung von Verklebung und Belagbildung. Sogar eine Dicke von über 6 µm bei zusätzlicher abrasiver Beanspruchung der beschichteten Oberfläche ist möglich.

Erfindungsgemäß ist es möglich, durch Wahl des Stickstoffanteiles den ohmschen Widerstand der erfindungsgemäßen Beschichtung einzustellen. Schichten mit einem hohen Stickstoffanteil weisen einen hohen ohmschen Widerstand und damit eine geringe Leitfähigkeit auf, wohingegen Schichtlagen mit einem geringeren Widerstand einen zum Aluminiumanteil geringeren Stickstoffgehalt aufweisen. In einer bevorzugten Ausführungsform mit sehr geringem ohmschen Widerstand besteht die Schicht bzw. bestehen die Schichten im wesentlichen aus reinem Aluminium oder enthält/enthalten zumindest praktisch keinen Stickstoff. Umgekehrt besteht bzw. bestehen bei Beschichtungen mit hohem ohmschen Widerstand die Schichtlage(n) zumindest überwiegend aus kovalenten Bindungen aus Aluminiumnitrid und aus Zirkoniumnitrid.

Zur Steigerung der Verschleißfähigkeit bzw. der chemischen Beständigkeit ist es erfindungsgemäß vorgesehen, zumindest zwei Beschichtungen jeweils alternierend anzuordnen, wobei Schichten mit hohem und Schichten mit geringem Stickstoffanteil übereinander abgeschieden werden. Vorteil einer solchen Beschichtung ist die Kombination verschiedener der vorstehend genannten Eigenschaften in einem Schichtsystem.

In Abhängigkeit von dem gewünschten Zweck ist es erfindungsgemäß auch vorgesehen, die Dicke der einzelnen Schichten untereinander zu variieren.

Das durch das erfindungsgemäße Verfahren enthaltenen Beschichtungssystem wird vorzugsweise so hergestellt, daß zur Bildung eines mit Edelgas angereicherten Plasmas zur Ionisierung des Al und Zr in einer Vakuumkammer eine elektrische Gasentladung gezündet und zur Bildung der Nitride des Al und Zr kontinuierlich Stickstoffgas zur Einstellung eines Reaktivgas-Partialdrucks als regelbare Größe für die Prozeßsteuerung zugeführt und kontinuierlich mittels Vakuumpumpen entfernt werden.

Die erfindungsgemäß einsetzbaren Reaktivgase sind Stickstoff, Kohlenstoff, Sauerstoff, Bor und Silicium enthaltende Gase sowie deren Mischungen sowie Mischungen mit weiteren Gasen wie z.B. Stickstoff mit Ethan und/oder Silan und/oder Diboran und/oder Acetylen, Stickstoff mit Kohlendioxid. Vorzugsweise werden die Gase, Reaktiv- und Edelgas, bereits in ionisiertem Zustand in die Vakuumkammer eingeleitet. Das zumindest eine weitere Reaktivgas, das in die Vakuumkammer während der erfindungsgemäßen Abscheidung der Beschichtung eingesetzt werden kann, kann vorteilhafterweise ebenfalls bereits in ionisiertem Zustand in die Vakuumkammer eingeleitet werden.

Für die Zwecke der Abscheidung der Beschichtungen ist es vorgesehen, zumindest jeweils ein Target aus Aluminium und ein Target aus Zirkonium in der Vakuumkammer anzuordnen. Alternativ ist es möglich, statt eines Targets aus Aluminium und eines Targets aus Zirkonium mindestens eine aus Aluminium und Zirkonium bestehende Legierung als Target einzusetzen. Vorteil dieses Einsatzes der Targets als Legierung ist dabei der Einsatz einer festen Legierungszusammensetzung für die metallischen Komponenten und die einfachere Ansteuerung des Herstellungsprozesses.

Zusätzlich kann erfindungsgemäß ein zusätzliches Target aus mindestens einem weiteren Werkstoff, vorzugsweise Elemente der Guppen IVa - VIa, Ib - IVb des Periodensystems, in der Vakuumkammer angeordnet sein. Eine Legierung aus mindestens zwei dieser Elemente ist ebenfalls erfindungsgemäß vorgesehen.

Beispielhaft sind hier Zirkonium-Silicium oder Zirkonium-Bor bzw. aus Molybdän und/oder Wolfram bestehende Legierungen genannt.

Die Abscheidung der Beschichtung erfolgt üblicherweise über Magnetfeld unterstützte Kathodenzerstäubung, wobei mindestens eine Zerstäubungskathode im DC-Betrieb, im gepulsten DC-Betrieb oder im HF- bzw. RF-Betrieb geregelt wird. Beim Einsatz von elektrisch leitenden Werkstoffen bzw. Legierungen werden die Targetkathoden vorzugsweise im DC-Betrieb, andere Legierungen im gepulsten DC-Betrieb betrieben. Nicht leitende Targets werden im HF- bzw. RF-Betrieb geregelt. Die Abscheidung der Beschichtung kann ebenfalls mittels einem Arc-, Lichtbogen-, lonenstrahl- oder Elektronenstrahl-Verdampfungsverfahren erfolgen.

Die erfindungsgemäß hergestellten Schichten können zur zumindest partiellen Oberflächenbeschichtung von Werkstoffen verwendet werden. Als Werkstoffe finden dabei Stahl, Aluminium-, Magnesium- oder Kupferlegierungen, Silicium oder siliciumhaltige Materialien, Glas, Keramik, Kunststoff oder gesinterte Hartstoffe, vorzugsweise Hartmetall oder Cermet oder faserverstärktes Glas Verwendung. Insbesondere handelt es sich dabei um Formwerkzeuge für die Kunststoff-, Kautschuk- oder Gummi- oder Glasverarbeitung, Werkzeuge für die Aluminium- oder Holzverarbeitung, medizinische oder chirurgische Instrumente, Bauteile für Maschinen, Motoren oder Automobile, Elektro- oder Elektronikbauteile, Schmuck oder Gebrauchsgegenstände, wobei es unabhängig davon ist, ob es sich bei den zu beschichtenden Teilen um Einzelteile, zusammengesetze Teile oder um die ganzen Teile der vorstehend genannten Produkte handelt.

Das erfindungsgemäß enthaltenen Schichtsystem aus der zumindest einen Beschichtung kann auch vorteilhafterweise auf ein bereits mit einer beliebigen Schicht beschichtetes Teil abgeschieden werden, so daß in Abhängigkeit von dem atomaren Verhältnis Aluminium zu Zirkon auf jedes beliebige Werkstück die Eigenschaften einer hohen chemischen Beständigkeit oder einer geringen Adhäsionsneigung übertragen werden können.

## Patentansprüche

1. Verfahren zum Abscheiden von Schichtsystemen für die zumindest partielle Beschichtung von Werkstoffen, bestehend aus mehreren Schichten, wobei jede Schicht jeweils aus einer Mischung aus Aluminiumnitrid und Zirkoniumnitrid besteht, wobei das atomare Verhältnis zwischen Al und Zr >0, jedoch ≤1 ist, bei dem
- zur Bildung eines mit Edelgas angereicherten Plasmas zur Ionisierung des Aluminiums und Zirkoniums in einer Vakuumkammer eine elektrische Gasentladung gezündet wird,
- zur Bildung der Aluminium- und Zirkoniumnitride kontinuierlich Stickstoff zur Einstellung eines Reaktivgas-Partialdrucks als regelbare Größe für die Prozesssteuerung zugeführt und entfernt wird, und
- Aluminium und Zirkonium in der Vakuumkammer in Form wenigstens eines Targets aus Aluminium und Zirkonium oder wenigstens eines Targets aus einer Legierung aus Aluminium und Zirkonium vorliegen,
**dadurch gekennzeichnet, dass**
zumindest zwei Beschichtungen jeweils alternierend angeordnet sind, wobei Schichten mit hohem und Schichten mit geringem Stickstoffanteil übereinander abgeschieden werden.

2. Verfahren nach Anspruch 1,
**dadurch gekennzeichnet, dass**
mindestens ein weiteres Kohlenstoff-, Sauerstoff-, Bor- oder Siliciumenthaltendes Reaktivgas oder deren Mischungen eingeleitet wird.

3. Verfahren nach einem der Ansprüche 1 oder 2,
**dadurch gekennzeichnet, dass**
mindestens ein Target aus mindestens einem weiteren Werkstoff aus den Gruppen Ib-IVb und IVa-Vla des Periodensystem eingesetzt wird, wobei diese Werkstoffe auch als Legierungen vorliegen können.

4. Verfahren nach einem der Ansprüche 1 bis 3,
**dadurch gekennzeichnet, dass**
die Beschichtung mit einer Dicke von zumindest 50nm hergestellt wird.

5. Verfahren nach einem der Ansprüche 1 bis 4,
**dadurch gekennzeichnet, dass**
die Dicke der Beschichtung zwischen 2 µm und 6 µm eingestellt wird.

6. Verfahren nach einem der Ansprüche 1 bis 5,
**dadurch gekennzeichnet, dass**
das atomare Verhältnis zwischen Al und Zr zwischen 0,5 und 0,7 eingestellt wird.

7. Verfahren nach einem der Ansprüche 1 bis 5,
**dadurch gekennzeichnet, dass**
das atomare Verhältnis zwischen Al und Zr zwischen 0,25 und 0,45 eingestellt wird.

8. Verfahren nach einem der Ansprüche 1 bis 7,
**dadurch gekennzeichnet, dass**
als Werkstoffe Stahl, Aluminium-, Magnesium- oder Kupferlegierungen, Silicium oder siliciumhaltigen Materialien, Glas, Keramik, Kunststoffe oder gesinterte Hartstoffe eingesetzt werden.

9. Verfahren nach Anspruch 8,
**dadurch gekennzeichnet, dass**
als Werkstoffe Hartmetall, Cermet oder faserverstärktes Glas eingesetzt werden.

## Claims

1. A process for the deposit of a laminate system for at least partial surface coating of a material, comprising multiple layers, each layer consisting of a mixture of aluminium nitride and zirconium nitride, whereas the atomic ratio between Al and Zr is > 0 and ≤ 1, wherein
- an electrical gas discharge is fired to form a plasma enriched with noble gas for ionization of aluminium and zirconium in a vacuum chamber,
- for the formation of nitrides of the aluminium and zirconium nitrogen is continuously supplied and removed for adjusting a reactive gas partial pressure as a regulable parameter for process control, and
- aluminium and zirconium are present in the vacuum chamber in form of at least one aluminium and zirconium target or at least one target comprising an aluminium and zirconium alloy,
**characterized in that**
at least two coatings are each arranged alternately, with layers having a high proportion of nitrogen and layers having a low proportion of nitrogen being deposited one upon the other.

2. The process according to claim 1,
**characterized in that**
at least one further reactive gas containing carbon, oxygen, boron, or silicon, or mixtures thereof is introduced.

3. The process according to claim 1 or 2,
**characterized in that**
at least one target comprising at least one further substance selected from Groups Ib-IVb and IVa-VIa of the periodic table is used, whereas these materials may also be present in form of alloys.

4. The process according to any of claims 1 to 3,
**characterized in that**
the coating being of a thickness of at least 50nm is formed.

5. The process according to any of claims 1 to 4,
**characterized in that**
the thickness of the coating is adjusted to between 2 µm and 6 µm.

6. The process according to any of claims 1 to 5,
**characterized in that**
the atomic ratio between Al and Zr is adjusted to between 0,5 and 0,7.

7. The process according to any of claims 1 to 5,
**characterized in that**
the atomic ratio between Al and Zr is adjusted to between 0,25 and 0,45.

8. The process according to any of claims 1 to 7,
**characterized in that**
steel, aluminium, magnesium or copper alloys, silicon or silicon-bearing materials, glass, ceramic, plastic or sintered hard substances are used as materials.

9. The process according to claim 8,
**characterized in that**
hard metal, cermet or fiber-reinforced glass are used as materials.

## Revendications

1. Procédé de déposition de systèmes de couches pour le revêtement au moins partiel de matériaux, se composant de plusieurs couches, chaque couche se composant d'un mélange de nitrure d'aluminium et de nitrure de zirconium, le rapport atomique entre Al et Zr étant > 0 mais ≤ 1, dans lequel :
- on enflamme une décharge gazeuse électrique dans une chambre à vide pour former un plasma enrichi en gaz noble pour ioniser l'aluminium et le zirconium,
- pour former le nitrure d'aluminium et le nitrure de zirconium, on introduit et on élimine de l'azote en continu pour réguler la pression partielle d'un gaz réactif en tant que variable de régulation pour le contrôle de procédé, et
- de l'aluminium et du zirconium sont présents dans la chambre à vide sous forme d'au moins une cible d'aluminium et de zirconium ou d'au moins une cible en un alliage d'aluminium et de zirconium,
**caractérisé en ce qu'**au moins deux revêtements sont disposés en alternance, des couches à forte teneur en azote et des couches à faible teneur en azote étant déposées les unes sur les autres.

2. Procédé selon la revendication 1,
**caractérisé en ce qu'**on introduit un gaz réactif supplémentaire contenant du carbone, de l'oxygène, du bore ou du silicium ou un mélange de ces derniers.

3. Procédé selon la revendication 1 ou 2,
**caractérisé en ce qu'**on utilise au moins une cible supplémentaire constituée d'au moins un autre matériau choisi parmi des groupes Ib-IVb et IVa-VIa de la classification périodique, ces matériaux pouvant aussi être présents sous forme d'alliages.

4. Procédé selon l'une quelconque des revendications 1 à 3,
**caractérisé en ce qu'**on fabrique un revêtement avec une épaisseur d'au moins 50 nm.

5. Procédé selon l'une quelconque des revendications 1 à 4,
**caractérisé en ce que** l'épaisseur du revêtement est fixée entre 2 µm et 6 µm.

6. Procédé selon l'une quelconque des revendications 1 à 5,
**caractérisé en ce que** le rapport atomique entre Al et Zr est fixé entre 0,5 et 0,7.

7. Procédé selon l'une quelconque des revendications 1 à 5,
**caractérisé en ce que** le rapport atomique entre Al et Zr est fixé entre 0,25 et 0,45.

8. Procédé selon l'une quelconque des revendications 1 à 7,
**caractérisé en ce qu'**on utilise comme matériaux des alliages d'acier, d'aluminium, de magnésium ou de cuivre, du silicium ou des matériaux contenant du silicium, du verre, de la céramique, des matières plastiques ou des substances dures frittées.

9. Procédé selon la revendication 8,
**caractérisé en ce qu'**on utilise comme matériaux un métal dur, du cermet ou du verre renforcé par des fibres.
